(19) Europäisches Patentamt
European Patent Office
Office européen des brevets

(11) **EP 3 677 926 A1**

(12) **EUROPEAN PATENT APPLICATION**
published in accordance with Art. 153(4) EPC

(43) Date of publication:
**08.07.2020 Bulletin 2020/28**

(21) Application number: **17923155.0**

(22) Date of filing: **29.08.2017**

(51) Int Cl.:
*G01R 31/36* (2020.01)   *H01M 10/48* (2006.01)
*H02J 7/00* (2006.01)

(86) International application number:
**PCT/JP2017/030979**

(87) International publication number:
**WO 2019/043792 (07.03.2019 Gazette 2019/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicants:
• **Kabushiki Kaisha Toshiba**
  **Minato-ku**
  **Tokyo 105-8001 (JP)**
• **Toshiba Infrastructure Systems &
  Solutions Corporation**
  **Kawasaki-shi, Kanagawa 212-0013 (JP)**

(72) Inventors:
• **KUWANO, Yuuki**
  **Tokyo 105-8001 (JP)**
• **SHIMIZU, Yosuke**
  **Tokyo 105-8001 (JP)**
• **HAGIWARA, Keizo**
  **Kawasaki-shi**
  **Kanagawa 212-8585 (JP)**

(74) Representative: **AWA Sweden AB**
**Junkersgatan 1**
**582 35 Linköping (SE)**

(54) **BATTERY SYSTEM AND VEHICLE**

(57) The battery system according to the embodiment accurately calculates the internal resistances of secondary battery cells, and includes a battery internal resistance calculator configured to: obtain open circuit voltages Vocv of the secondary battery cells; during charging of battery modules MDL11 to MDLnm, obtain closed circuit voltages Vccv of the secondary battery cells from the battery monitoring circuits CB11 to CBnm in a predetermined order, and then obtain closed circuit voltages of the secondary battery cells from the battery monitoring circuits CB11 to CBnm in a reverse order of the predetermined order; calculate an average value of the closed circuit voltages Vccv obtained for each of the secondary battery cells; and calculate the internal resistances of the secondary battery cells based on the open circuit voltages Vocv, a charging current value of the battery modules MDL1 to MDLnm obtained from a current sensor, and the average values of the closed circuit voltages Vccv.

FIG. 5

EP 3 677 926 A1

## Description

FIELD

Embodiments described herein relate generally to a battery system and a vehicle.

BACKGROUND

A battery device can be configured by connecting a plurality of battery modules in parallel according to the required charging/discharging capacity. The battery modules each include, for example, an assembled battery including a plurality of secondary battery cells, and a battery monitoring circuit configured to detect a voltage of each of the secondary battery cells and a charging/discharging current of the assembled battery.

The battery device is mounted as a power source of various electronic devices such as a portable device and a mobile object. For example, a hybrid vehicle drives a load with power (mechanical energy) obtained from a prime mover and electric energy obtained from an electric motor. The hybrid vehicle includes DC links electrically connecting two inverters, and a battery device can be electrically connected to the DC links. The prime mover is electrically connected to the DC links via a generator and an inverter. The electric motor is electrically connected to the DC links via an inverter.

It is known that the secondary battery cell deteriorates due to the influence of the use environment, the number of charge/discharge cycles, and the like. Conventionally, estimating the deterioration state based on the internal resistance of the secondary battery cell has been proposed.

CITATION LIST

PATENT LITERATURE

[Patent Literature 1] Jpn. Pat. Appln. KOKAI Publication No. 2016-125932

SUMMARY

TECHNICAL PROBLEM

For example, in calculation of internal resistances using closed circuit voltages of a plurality of secondary battery cells, if errors in measured closed circuit voltage values increase, the calculated internal resistances become less accurate.

While a current is flowing through a secondary battery cell, the closed circuit voltage of the secondary battery cell changes with time. Therefore, in order to increase the accuracy of calculating the internal resistances, it is desirable to synchronize the voltage measurement timings of all the secondary battery cells of a plurality of battery modules.

However, as the capacity of the battery device increases, the number of battery modules controlled by the battery management device increases; therefore, it has been difficult for the battery management circuit to synchronize the timings of measuring the closed circuit voltages of a plurality of secondary battery cells of a plurality of battery modules.

Embodiments of the present invention have been made in view of the above circumstances, and are intended to provide a battery system and vehicle that accurately calculate the internal resistances of secondary battery cells.

SOLUTION TO PROBLEM

The battery system according to the present embodiment comprises:
a battery device including:

a plurality of battery modules each including: an assembled battery including a plurality of secondary battery cells; and a battery monitoring circuit configured to detect a voltage of each of the secondary battery cells;
a current sensor configured to detect a current flowing through the battery modules; and
a battery management circuit configured to control the battery monitoring circuits and obtain detected value of the current flowing through the battery modules and detected values of voltages of the secondary battery cells; and
a controller including a battery internal resistance calculator configured to: obtain open circuit voltages of the secondary battery cells; during charging of the battery modules, obtain closed circuit voltages of the secondary battery cells from the battery monitoring circuits in a predetermined order, and then obtain closed circuit voltages of the secondary battery cells from the battery monitoring circuits in a reverse order of the predetermined order; calculate an average value of the closed circuit voltages obtained for each of the secondary battery cells; and calculate internal resistances of the secondary battery cells based on the open circuit voltages, a charging current value of the battery modules obtained from the current sensor, and the average values.

BRIEF DESCRIPTION OF THE DRAWINGS

FIG. 1 is a block diagram schematically showing a configuration example of a hybrid vehicle equipped with a battery system of the present embodiment.
FIG. 2 schematically shows a configuration example of the battery device shown in FIG. 1.
FIG. 3 is a diagram showing an example of a temporal change in the charging current and voltage of a secondary battery cell when charging the secondary battery cell.

FIG. 4 is a flowchart for explaining an example of the operation of a battery internal resistance calculator of the battery system according to the embodiment.

FIG. 5 is a diagram for explaining an example of the timings of detecting closed circuit voltages of secondary battery cells obtained by the battery internal resistance calculator.

## DETAILED DESCRIPTION

Hereinafter, a battery system and vehicle according to an embodiment will be described in detail with reference to the drawings.

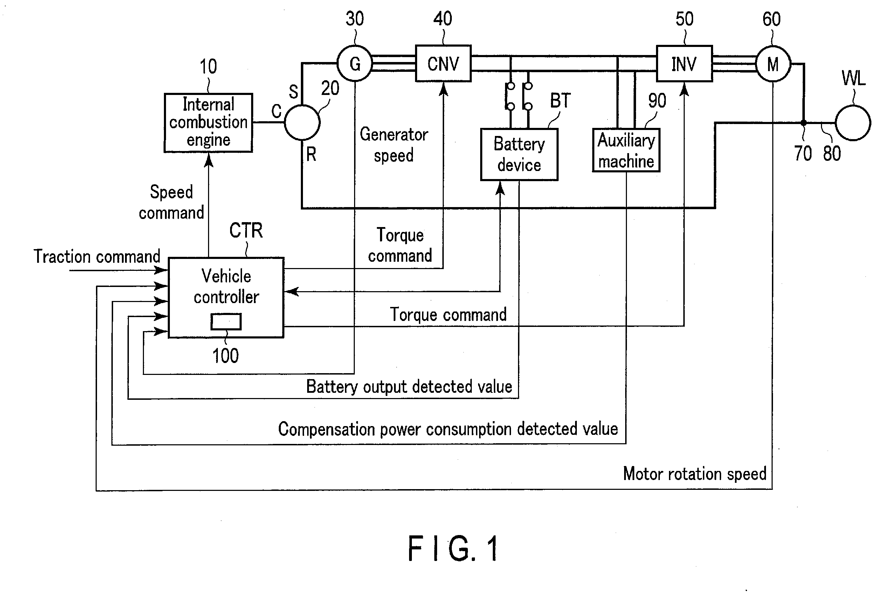

FIG. 1 is a block diagram schematically showing a configuration example of a hybrid vehicle equipped with a battery system of the present embodiment.

The hybrid vehicle includes an internal combustion engine 10, a power dividing mechanism 20, a generator (first electric motor) 30, a converter 40, an inverter 50, a motor (second electric motor) 60, a power combining mechanism 70, an axle 80, an auxiliary machine 90, a wheel WL, a vehicle controller CTR, and a battery device BT.

The internal combustion engine 10 is a prime mover, such as a gasoline engine or a diesel engine, which generates mechanical energy for driving the vehicle.

The power dividing mechanism 20 is a triaxial power dividing mechanism that divides mechanical energy generated by the internal combustion engine 10 into energy supplied to the generator 30 side and energy supplied to the wheel WL side (axle 80 side).

The power dividing mechanism 20 is, for example, a planetary gear mechanism (not shown), and includes a sun gear S, a planetary gear P circumscribing the sun gear S, a ring gear R in which the planetary gear P is inscribed, and a planetary carrier C that rotates along the orbit of the planetary gear P. In the present embodiment, the planetary carrier C is rotated by mechanical energy generated by the internal combustion engine 10. The rotational power of the sun gear S is transmitted to the generator 30. The rotational power of the ring gear R is transmitted to the power combining mechanism 70 connected to the axle 80.

The converter 40 is control means for controlling the operation of the generator 30, which can convert three-phase AC power output from the generator 30 into DC power for a regenerative operation, and convert DC power supplied from the DC links into three-phase AC power and supply it to the generator 30 for a power running operation of the generator 30. The converter 40 is electrically connected to the inverter 50, the battery device BT, and the auxiliary machine 90 via the DC links.

The inverter 50 can convert DC power supplied from the DC links into AC power and output it to the motor 60. The inverter 50 can also convert AC power supplied from the motor 60 into DC power and output it to the DC links.

The motor 60 is an electric motor driven by AC power supplied from the inverter 50, and converts electric energy into mechanical energy and outputs it to the power combining mechanism 70.

The power combining mechanism 70 transmits, to the axle 80, energy obtained by combining the mechanical energy transmitted from the ring gear R of the power dividing mechanism 20 and the mechanical energy supplied from the inverter 50. The wheel WL is rotationally driven via the axle 80.

The battery device BT can be charged with power supplied from the DC links, and can discharge power to the DC links. The battery device BT is connected to the DC links via a breaker. The breaker is, for example, an electromagnetic contactor, and its operation is controlled by the vehicle control circuit CTR.

The auxiliary machine 90 is a load, such as a lighting device, mounted in the vehicle. The auxiliary machine 90 is connected to the battery device BT, the converter 40, and the inverter 50 via the DC links, and is driven by energy supplied from the DC links.

The vehicle controller CTR is a host controller that controls the internal combustion engine 10, the generator 30, the converter 40, the inverter 50, the motor 60, and the battery device BT to operate in conjunction with each other. The vehicle controller CTR is an arithmetic circuit including at least one processor, such as a central processing unit (CPU) or a micro processing unit (MPU), and a memory.

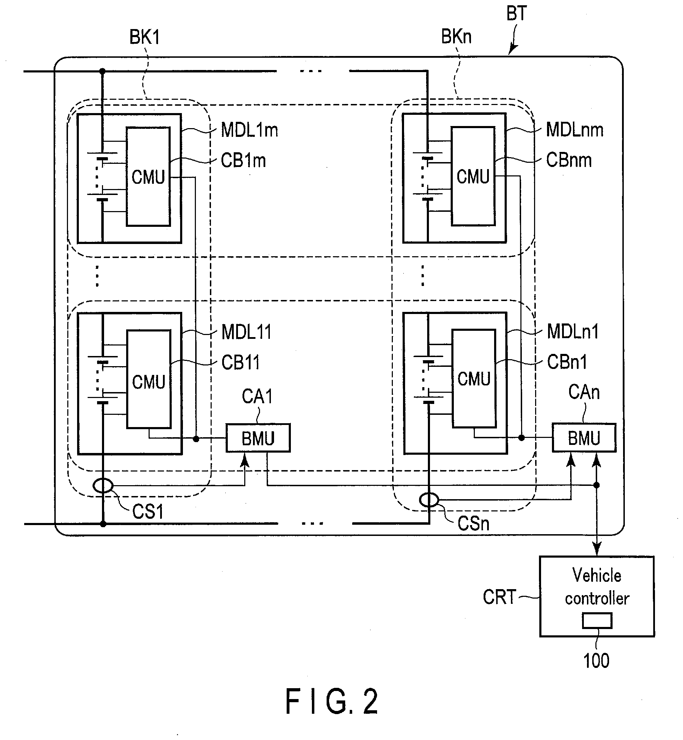

FIG. 2 schematically shows a configuration example of the battery device shown in FIG. 1.

The battery device BT includes a plurality of battery banks BK1 to BKn connected in parallel to the DC links and a plurality of battery management circuits (battery management units (BMUs)) CA1 to CAn corresponding to the battery banks BK1 to BKn. The battery banks BK1 to BKn each include a plurality of battery modules MDL11 to MDLnm and a current sensor CS.

The operations of the battery modules MDL11 to MDLnm included in each of the battery banks BNK1 to BNKn are controlled by the corresponding battery management circuits CA1 to CAn. In the present embodiment, m (positive integer) battery modules MDL11 to MDL1m, ..., and MDLn1 to MDLnm are connected in series in the respective battery banks BNK1 to BNKn, and n (positive integer) battery banks BNK1 to BNKn are connected in parallel.

The battery modules MDL11 to MDLnm each can be electrically connected to the DC links via a switcher (not shown) such as a contactor. The battery management circuits CA1 to CAn can switch the electrical connections between the DC links and the respective battery banks BK1 to BKn by controlling the switchers.

The battery modules MDL11 to MDLnm each include an assembled battery including a plurality of secondary battery cells, and battery monitoring circuits (cell monitoring units (CMU)) CB11 to CBnm.

The secondary battery cell is a chargeable and dischargeable battery and is, for example, a lithium ion battery or a nickel metal hydride battery.

The battery monitoring circuits CB11 to CBnm included in each of the battery banks BK1 to BKn are communicatively connected to a common battery management circuit CA1 to CAn via a transmission line. In the present embodiment, the battery monitoring circuits CB11 to CBnm can perform serial communication with the corresponding battery management circuits CA1 to CAn, and the battery monitoring circuits CB11 to CBnm communicate with the battery management circuits CA1 to CAn based on a control area network (CAN) protocol. Note that the battery monitoring circuits CB11 to CBnm may communicate with the battery management circuits CA1 to CAn by wired communication means or wireless communication means.

The battery monitoring circuits CB11 to CBnm each detect the voltages of the secondary battery cells included in the assembled battery and the temperature of the vicinity of the assembled battery. The battery monitoring circuits CB11 to CBnm can output detected values to the corresponding battery management circuits CA1 to CAn in a predetermined communication cycle ($\alpha$ [second]). The operations of the battery monitoring circuits CB11 to CBnm are controlled by control signals from the battery management circuits CA1 to CAn.

The current sensors CS1 to CSn each detect currents flowing through the assembled batteries included in the corresponding battery bank BK1 to BKn, and supply the values of the detected currents to the corresponding battery management circuit CA1 to CAn.

The battery management circuits CA1 to CAn are communicatively connected to the vehicle controller CTR via a transmission line. In the present embodiment, the battery management circuits CA1 to CAn communicate with the vehicle controller CTR based on, for example, the control area network (CAN) protocol. Note that the battery management circuits CA1 to CAn may communicate with the vehicle controller CTR by wired communication means or wireless communication means.

The battery management circuits CA1 to CAn each output voltage values and temperature values received from the corresponding battery monitoring circuit CB11 to CBnm and current values received from the corresponding current sensor CS1 to CSn to the vehicle controller CTR in a predetermined cycle. The operations of the battery management circuits CA1 to CAn are controlled by control signals from the vehicle controller CTR.

The vehicle controller CTR includes a battery internal resistance calculator 100 that calculates internal resistance values of the secondary battery cells based on the voltage values and current values received from the battery management circuits CA1 to CAn. The battery internal resistance calculator 100 may be configured by software recorded in a memory and executed by a processor of the vehicle controller CTR.

The battery internal resistance calculator 100 calculates an internal resistance R of a secondary battery cell based on an open circuit voltage (OCV) value Vocv, closed circuit voltage (CCV) value Vccv, and current value I of the secondary battery cell. The internal resistance of the secondary battery cell can be calculated by, for example, the following formula (1):

$$R \ [\Omega] \ = \ (Vccv \ - \ Vocv)/I \ (1)$$

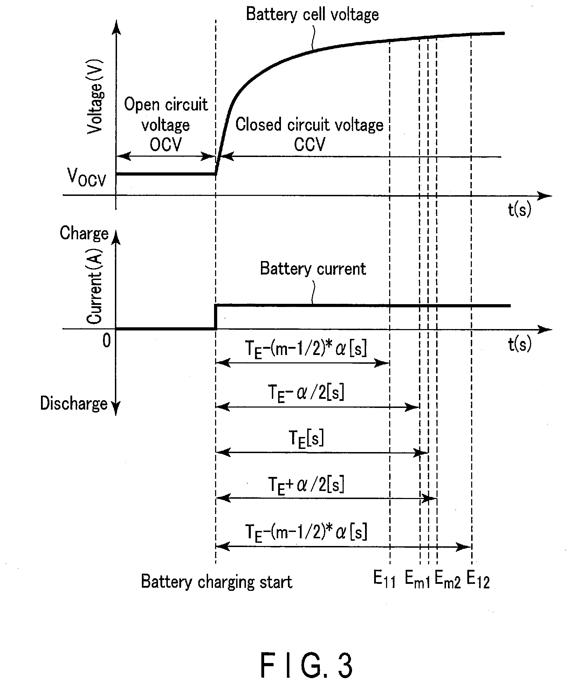

FIG. 3 is a diagram showing an example of a temporal change in the charging current and voltage of a secondary battery cell when charging the secondary battery cell.

FIG. 3 shows a period in which constant current charging is performed from the charging start time of the secondary battery cell.

In the present embodiment, the battery internal resistance calculator 100 detects a closed circuit voltage Vccv when the secondary battery cell is charged.

Before charging of the battery device BT starts, the voltage of the secondary battery cell is the open circuit voltage Vocv. When charging of the secondary battery cell starts, the battery current takes a predetermined value. After charging starts, the battery current takes a substantially constant value and then, the closed circuit voltage Vccv of the secondary battery cell rises, and the change in the closed circuit voltage Vccv becomes slow with time.

Here, for example, in a battery device including a plurality of battery modules, when battery management circuits subsequently obtain voltage values of secondary battery cells from a plurality of battery monitoring circuits in each battery bank, there is a difference in timing of detecting the voltage of the secondary battery cell. For example, as the number of battery modules included in the battery bank increases, the difference in detection timing between the voltage value first acquired and the voltage last acquired increases.

As described above, the closed circuit voltage Vccv of the secondary battery cell is a value that varies with the passage of time from the start of charging; therefore, as the difference in timing of detecting the closed circuit voltage Vccv increases among a plurality of secondary voltage cells, the calculation accuracy of the internal resistances of the secondary battery cells may deteriorate.

The battery internal resistance calculator 100 of the present embodiment suppresses deterioration in calculation accuracy of internal resistances which is caused by the difference in timing of detecting the closed circuit voltage Vccv.

Hereinafter, an example of the operation of the vehicle controller CTR to calculate the internal resistance values of the secondary battery cells will be described. The present embodiment suppresses deterioration in calculation accuracy of the internal resistances of the secondary battery cells of the battery modules included in each of the battery banks BK1 to BKn.

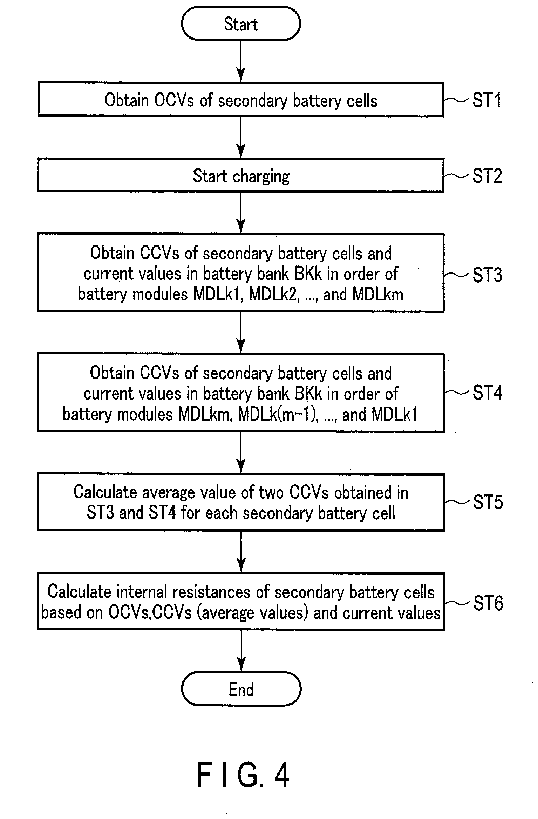

FIG. 4 is a flowchart for explaining an example of the operation of the battery internal resistance calculator of the battery system according to the embodiment.

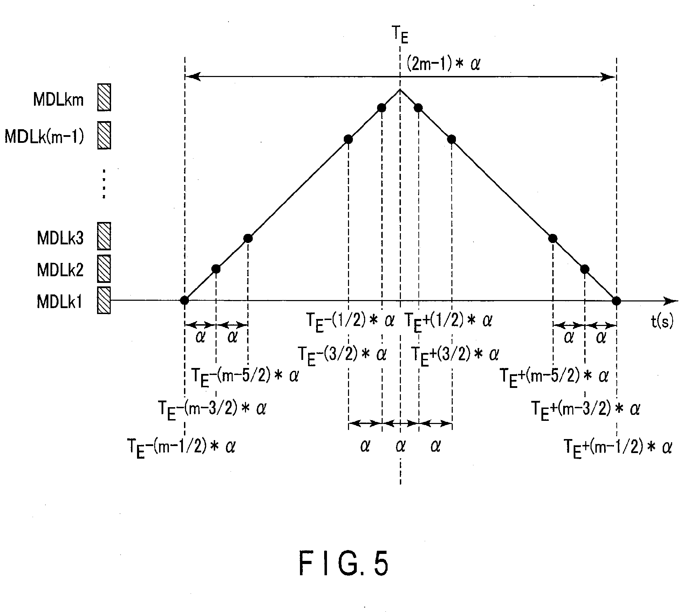

FIG. 5 is a diagram for explaining an example of the timings of detecting closed circuit voltages of the secondary battery cells obtained by the battery internal resistance calculator.

The battery internal resistance calculator 100 controls the battery management circuits CA1 to CAn to detect the open circuit voltages Vocv of the secondary battery cells included in the corresponding battery bank BK1 to BKn in a state where the battery bank BK1 to BKn is not electrically connected to the DC links (step ST1).

Subsequently, the battery internal resistance calculator 100 controls the battery management circuits CA1 to CAn to electrically connect the battery banks BK1 to BKn to the DC links, and supply a charging current from the DC links to the battery banks BK1 to BKn, thereby starting charging of the battery device BT (step ST2). At this time, the vehicle controller CTR can charge the battery device BT by supplying mechanical energy obtained from the internal combustion engine 10 to the DC links via the power dividing mechanism 20 and the converter 30 in the state where the vehicle is stopped.

After starting charging of the battery device BT, the battery internal resistance calculator 100 requests the closed circuit voltages Vccv and current value of the secondary battery cells included in the battery banks BK1 to BKn from the battery management circuits CA1 to CAn.

Hereinafter, an operation of the battery internal resistance calculator 100 to obtain the closed circuit voltages Vccv of the battery management circuit CAk of the k-th battery bank BKk will be described. Note that k is a positive integer of 1 to n.

Upon receipt of a request for the closed circuit voltages Vccv and current value of the secondary battery cells from the battery internal resistance calculator 100 of the vehicle controller CTR, the battery management circuit CAk sequentially obtains the closed circuit voltages Vccv of the secondary battery cells from the battery monitoring circuits CBk1 to CBkm, for exaample, in the order of battery module MDLk1, battery module MDLk2, battery module MDLk3, ..., and battery module MDLkm, and transmits them to the battery internal resistance calculator 100 of the vehicle controller CTR (step ST3).

Subsequently, the battery management circuit CAk sequentially obtains the closed circuit voltages Vccv of the secondary battery cells from the battery monitoring circuits CBkm to CBk1 in the order of battery module MDLkm, battery module MDLk(m-1), ..., and battery module MDL1, and transmits them to the battery internal resistance calculator 100 of the vehicle controller CTR (step ST4).

In steps ST3 and ST4, the differences in timing of detecting the closed circuit voltage Vccv, for example, between battery module MDLk1 and battery module MDLk2, between battery module MDLk2 and battery module MDLk3, ..., and between battery module MDLk(m-1) and battery module MDLkm, are substantially equal to the communication cycle $\alpha$ [seconds] of the battery monitoring circuits CBk1 to CBkm.

The battery management circuit CAk also transmits the detected current value obtained from the current sensor CS to the vehicle controller CTR.

As described above, the battery internal resistance calculator 100 obtains the values of the two closed circuit voltages Vccv for each of the secondary battery cells from the battery management circuits CA1 to CAn, and calculates the value of the internal resistance for each of the secondary battery cells based on the average value of the two closed circuit voltages Vccv obtained in step ST3 and step ST4.

In step ST3, for example, when the closed circuit voltages Vccv of the secondary battery cells of battery module MDLk1 are detected at time $T_E - (m - 1/2) \times \alpha$ after the start of charging, the closed circuit voltages Vccv of the secondary battery cells of battery module MDLk2 and those of battery module MDLk3 are sequentially detected at time $T_E - (m - 3/2) \times \alpha$ and time $T_E - (m - 5/2) \times \alpha$ after the start of charging, and those of battery module MDLkm are detected at time $T_E - \alpha/2$ after the start of charging.

Subsequently, in step ST4, the closed circuit voltages Vccv of the secondary battery cells of battery module MDLKkm and those of battery module MDLk(m-1) are sequentially detected at time $T_E + \alpha/2$ and $T_E\ 3/2 \times \alpha$ after the start of charging and, finally, the closed circuit voltages Vccv of the secondary battery cells of battery module MDLk1 are detected at time $T_E + (m - 1/2) \times \alpha$ after the start of charging.

The battery internal resistance calculator 100 calculates the average value of the closed circuit voltages Vccv detected in step ST3 and step ST4 for each of the secondary battery cells at the above-described timing. The battery internal resistance calculator 100 may use the obtained average value of the closed circuit voltages Vccv as the closed circuit voltage Vccv of the secondary battery cell as of time $T_E$ after the start of charging (step ST5).

The battery internal resistance calculator 100 calculates the internal resistance R of each secondary battery cell as of time $T_E$ after the start of charging by equation (1) based on the open circuit voltage Vocv of the secondary battery cell obtained in step ST1, the average value of the closed circuit voltages Vccv of the secondary battery cell calculated in step ST5, and the current value of the secondary battery cell (step ST6).

As described above, calculating the internal resistance of each secondary battery cell using the average value of the closed circuit voltages Vccv of the secondary battery cell can suppress deterioration in internal resistance calculation accuracy caused by the differences in timing of detecting the closed circuit voltages Vccv of the secondary battery cells.

That is, the present embodiment can provide a battery system and vehicle that accurately calculate the internal resistances of secondary battery cells.

While some embodiments of the present invention have been described, the embodiments have been presented as examples, and are not intended to limit the scope of the invention. These novel embodiments may be embodied in various forms, and various omissions, replacements, and changes can be made thereto without departing from the spirit of the invention. The embodiments and their modifications are included in the scope and spirit of the invention and are included in the scope of the claimed inventions and their equivalents.

For example, in the above-described embodiment, in calculation of the internal resistances of the secondary battery cells, when the closed circuit voltages Vccv of the secondary battery cells are first obtained for the battery modules MDLk1 to MDLkm included in battery bank BKk, the closed circuit voltages Vccv are obtained in the order of battery modules MDLk1, MDLk2, ..., and MDLm, and when the closed circuit voltages Vccv of the secondary battery cells are secondly obtained, the closed circuit voltages Vccv are obtained in the order of battery modules MDLkm, MDLk(m-1), ..., and MDL1; however, the orders of obtaining the closed circuit voltages Vccv of the secondary battery cells in battery bank Bk are not limited to these.

Regarding the battery modules MDLk1, MDLk2, ..., and MDLkm controlled by the battery management circuit CAk, the closed circuit voltages Vccv of the secondary battery cells may be first obtained in any predetermined order, and then secondly obtained in the reverse order of the first order.

In the case where the battery internal resistance calculator 100 previously controls the battery management circuit CAk to obtain the closed circuit voltages Vccv in a predetermined order, for example, the order of battery modules MDLk1, MDLk2, ..., and MDLkm, and then obtain the closed circuit voltages Vccv in the reverse order of the predetermined order, i.e., the order of battery modules MDLkm, MDLk(m-1), ..., and MDLk1 and thereby calculates the internal resistances of the secondary battery modules by using the average values of the closed circuit voltages Vccv, when the internal resistances of the secondary battery modules are calculated next, the closed circuit voltages Vccv may be first obtained in the order of battery modules MDLkm, MDLk(m-1), ..., and MDLk1, and then obtained in the order of battery modules MDLk1, MDLk2, ..., and MDLkm. When calculating the internal resistances of the secondary battery cells, the battery internal resistance calculator 100 may record a predetermined order or a reverse order of the predetermined order in the memory of the vehicle controller CTR, and read the predetermined order or the reverse order of the predetermined order from the memory when next calculating the internal resistances of the secondary battery cells.

In addition, when calculating the internal resistances of the secondary battery cells, the battery internal resistance calculator 100 may obtain the closed circuit voltages Vccv of the secondary battery cells in an order different from the order in which the closed circuit voltages Vccv are obtained when the internal resistances of the secondary battery cells are previously calculated.

For example, in the case where the battery internal resistance calculator 100 previously controls the battery management circuit CAk to obtain the closed circuit voltages Vccv in a predetermined order, for example, the order of battery modules MDLk1, MDLk2, ..., and MDLkm, then obtain the closed circuit voltages Vccv in the reverse order of the predetermined order, i.e., the order of battery modules MDLkm, MDLk(m-1), ..., and MDLk1 and thereby calculates the internal resistances of the secondary battery modules by using the average values of the closed circuit voltages Vccv, when the internal resistances of the secondary battery modules are calculated next, the closed circuit voltages Vccv may be first obtained in the order of battery modules MDLk2, MDLk3, ..., MDLkm, and MDLk1, and then obtained in the order of battery modules MDLk1, MDLkm, MDLk(m-1), ..., and MDLk2.

By the battery internal resistance calculator 100 obtaining the closed circuit voltages Vccv of the secondary battery cells in an order different from the previous order of obtaining the closed circuit voltages Vccv of the secondary battery cells, bias in the calculation results of the internal resistances of the secondary battery cells can be suppressed.

In the above-described embodiment, the battery internal resistance calculator 100 is included in the vehicle controller CTR; however, each of the battery management circuits CA1 to CAn may include part or all of the configuration of the battery internal resistance calculator 100.

In any case, the same effect as the above-described embodiment can be obtained.

**Claims**

1. A battery system comprising:

   a battery device including:

   a plurality of battery modules each including: an assembled battery including a plurality of secondary battery cells; and a battery monitoring circuit configured to detect a voltage of each of the secondary battery cells;
   a current sensor configured to detect a current flowing through the battery modules; and
   a battery management circuit configured to control the battery monitoring circuits and obtain detected value of the current flowing through the battery modules and detected values of voltages of the secondary battery cells; and

a controller including a battery internal resistance calculator configured to: obtain open circuit voltages of the secondary battery cells; during charging of the battery modules, obtain closed circuit voltages of the secondary battery cells from the battery monitoring circuits in a predetermined order, and then obtain closed circuit voltages of the secondary battery cells from the battery monitoring circuits in a reverse order of the predetermined order; calculate an average value of the closed circuit voltages obtained for each of the secondary battery cells; and calculate internal resistances of the secondary battery cells based on the open circuit voltages, a charging current value of the battery modules obtained from the current sensor, and the average values.

2. The battery system according to claim 1, wherein when secondly calculating the internal resistances of the secondary battery cells, the battery internal resistance calculator obtains closed circuit voltages of the secondary battery cells from the battery monitoring circuits in the reverse order of the predetermined order, and then obtains closed circuit voltages of the secondary battery cells from the battery monitoring circuits in the predetermined order.

3. A vehicle comprising:

an internal combustion engine;
a first electric motor;
a power dividing mechanism configured to distribute power of the internal combustion engine to the first electric motor and a power combining mechanism;
a second electric motor connected to the power combining mechanism;
a converter configured to drive the first electric motor;
an inverter connected to the converter via DC links and configured to drive the second electric motor;
an axle configured to rotate with energy supplied from the power combining mechanism;
a battery device connected to the DC links and including:

a plurality of battery modules each including: an assembled battery including a plurality of secondary battery cells; and a battery monitoring circuit configured to detect a voltage of each of the secondary battery cells;
a current sensor configured to detect a current flowing through the battery modules; and
a battery management circuit configured to control the battery monitoring circuits and obtain detected value of the current flowing through the battery modules and detected values of voltages of the secondary battery cells; and

a controller including a battery internal resistance calculator configured to: obtain open circuit voltages of the secondary battery cells; during charging of the battery modules, obtain closed circuit voltages of the secondary battery cells from the battery monitoring circuits in a predetermined order, and then obtain closed circuit voltages of the secondary battery cells from the battery monitoring circuits in a reverse order of the predetermined order; calculate an average value of the closed circuit voltages obtained for each of the secondary battery cells; and calculate internal resistances of the secondary battery cells based on the open circuit voltages, a charging current value of the battery modules obtained from the current sensor, and the average values.

F I G. 1

F I G. 2

F I G. 3

Start

Obtain OCVs of secondary battery cells ⸻ ST1

Start charging ⸻ ST2

Obtain CCVs of secondary battery cells and
current values in battery bank BKk in order of
battery modules MDLk1, MDLk2, ..., and MDLkm ⸻ ST3

Obtain CCVs of secondary battery cells and
current values in battery bank BKk in order of
battery modules MDLkm, MDLk(m-1), ..., and MDLk1 ⸻ ST4

Calculate average value of two CCVs obtained in
ST3 and ST4 for each secondary battery cell ⸻ ST5

Calculate internal resistances of secondary battery cells
based on OCVs,CCVs (average values) and current values ⸻ ST6

End

F I G. 4

FIG. 5

## INTERNATIONAL SEARCH REPORT

| International application No. |
| --- |
| PCT/JP2017/030979 |

A. CLASSIFICATION OF SUBJECT MATTER
*G01R31/36*(2006.01)i, *H01M10/48*(2006.01)i, *H02J7/00*(2006.01)i

According to International Patent Classification (IPC) or to both national classification and IPC

B. FIELDS SEARCHED

Minimum documentation searched (classification system followed by classification symbols)
G01R31/36, H01M10/48, H02J7/00

Documentation searched other than minimum documentation to the extent that such documents are included in the fields searched
Jitsuyo Shinan Koho          1922–1996   Jitsuyo Shinan Toroku Koho   1996–2017
Kokai Jitsuyo Shinan Koho    1971–2017   Toroku Jitsuyo Shinan Koho   1994–2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2014-157662 A (Toyota Motor Corp.), 28 August 2014 (28.08.2014), paragraphs [0004] to [0008], [0018] to [0019], [0022], [0039], [0134] to [0138]; all drawings (Family: none) | 1-3 |
| Y | JP 2007-240299 A (Yazaki Corp.), 20 September 2007 (20.09.2007), paragraphs [0002], [0020], [0025], [0048] to [0049], [0053]; all drawings (Family: none) | 1-3 |

☒ Further documents are listed in the continuation of Box C.          ☐ See patent family annex.

| | |
| --- | --- |
| *    Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |
| Date of the actual completion of the international search<br>    14 November 2017 (14.11.17) | Date of mailing of the international search report<br>    21 November 2017 (21.11.17) |
| Name and mailing address of the ISA/<br>    Japan Patent Office<br>    3-4-3,Kasumigaseki,Chiyoda-ku,<br>    Tokyo 100-8915,Japan | Authorized officer<br><br><br>Telephone No. |

Form PCT/ISA/210 (second sheet) (January 2015)

**INTERNATIONAL SEARCH REPORT**

International application No.

PCT/JP2017/030979

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2014/115294 A1  (Hitachi Vehicle Energy, Ltd.), 31 July 2014 (31.07.2014), paragraphs [0011] to [0022]; all drawings & US 2015/0301115 A1 paragraphs [0021] to [0032]; all drawings | 1-3 |
| Y | JP 2015-230235 A  (Hitachi, Ltd.), 21 December 2015 (21.12.2015), paragraphs [0008], [0043] to [0052]; all drawings (Family: none) | 3 |
| Y | JP 2015-52513 A  (Toyota Motor Corp.), 19 March 2015 (19.03.2015), paragraphs [0001], [0017] to [0021]; all drawings (Family: none) | 3 |
| Y | JP 2010-158097 A  (Toyota Motor Corp.), 15 July 2010 (15.07.2010), paragraphs [0014], [0020]; all drawings (Family: none) | 3 |
| A | WO 2014/068864 A1  (Sanyo Electric Co., Ltd.), 08 May 2014 (08.05.2014), paragraphs [0022] to [0023]; all drawings (Family: none) | 1-3 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016125932 A